# EUROPÄISCHE PATENTSCHRIFT

(11) **EP 4 128 539 B1**
(45) Veröffentlichungstag und Bekanntmachung des Hinweises auf die Patenterteilung: **16.09.2026**
(21) Anmeldenummer: 21716121.5
(22) Anmeldetag: 26.03.2021
(51) Int. Cl.: H03M 1/12

(54) **VERFAHREN ZUR ZEITLICH SYNCHRONISIERTEN EINGABE UND/ODER AUSGABE VON SIGNALEN MIT WÄHLBARER ABTASTRATE**
METHOD FOR THE TIME-SYNCHRONISED INPUT AND/OR OUTPUT OF SIGNALS WITH A SELECTABLE SAMPLING RATE
PROCÉDÉ D'ENTRÉE ET/OU DE SORTIE SYNCHRONISÉE DANS LE TEMPS DE SIGNAUX AVEC UN TAUX D'ÉCHANTILLONNAGE SÉLECTIONNABLE

(30) Priorität: 27.03.2020 DE 102020108631
(43) Veröffentlichungstag der Anmeldung: 08.02.2023
(73) Patentinhaber: dSPACE SE & Co. KG, 33102 Paderborn (DE)
(72) Erfinder: LUBELEY, Dominik, 33102 Paderborn (DE); SCHLENGER, Marc, 33102 Paderborn (DE); GRUBER, Paul, 33102 Paderborn (DE)
(86) Internationale Anmeldenummer: PCT/EP2021/057961
(87) Internationale Veröffentlichungsnummer: WO 2021/191428

(56) Entgegenhaltungen:
- WO-A2-99/66377

## Beschreibung

Die Erfindung betrifft ein Verfahren zur zeitlich synchronisierten Eingabe und/oder Ausgabe von Signalen mit wählbarer Abtastrate, bevorzugt synchron erfassten Signalen an mehreren Eingabekanälen einer elektronischen Schaltung.

Unter einem Signal kann hierbei eine kontinuierlich oder diskret änderbare physikalische Größe wie insbesondere eine elektrische Spannung oder ein digitaler Wert als Repräsentant einer Information verstanden werden; z.B. kann in der TTL-Technologie ein elektrischer Spannungswert größer als 2,4 V einen logischen "Wahr"-Wert als digitale Information repräsentieren.

Elektronische Schaltungen mit Ein- und/oder Ausgabekanälen sind im Stand der Technik allgemein bekannt und werden häufig als I/O-Schaltungen bezeichnet. Sie dienen dazu, um an den Pins der Ausgabekanäle elektrische Signale auszugeben und/oder an den Pins der Eingangskanäle dort anliegende elektrische Signale zu erfassen, z.B. durch eine Analog/Digital-Wandlung, um die erfassten Signale einer Weiterverarbeitung zuzuführen, sei es auf der genannten elektronischen Schaltung oder auf weiterer Elektronik, die mit der Schaltung verbunden ist.

Unter einem Kanal kann dabei allgemein eine Anordnung elektronischer Schaltkreise zwischen einer Eingangsseite und einer Ausgangsseite verstanden werden, die eine dem Kanal zugeordnete Funktion durchführen, wie z.B. die schon genannte Analog/Digital-Wandlung und/oder eine analoge Verstärkung oder Filterung. Zumindest eine Seite von Eingangsseite und Ausgangsseite kann durch einen Pin gegeben sein, an dem ein elektrisches Signal (analog oder digital) physikalisch anliegt. Die andere Seite kann je nach Kanalfunktion ebenso durch einen Pin gegeben sein, z.B. bei einem analogen Verstärker oder auch durch einen Speicher oder ein Register, z.B. bei einem Wandler, der digitale Werte an der Ausgangsseite bereitstellt oder an der Eingangsseite benötigt.

Ein typisches und bevorzugtes Anwendungsgebiet, auf welches die Erfindung jedoch nicht beschränkt ist, stellt die HIL-Simulation, die sogenannte Hardware-in-the-Loop-Simulation dar. Hierbei werden Steuergeräte, z.B. Kfz-Steuergeräte einer Prüfung auf korrekte Funktion unterzogen, wofür das zu prüfende Steuergerät an eine Schaltung der eingangs genannten Art angeschlossen wird, um über die Schaltung Signale auf das Steuergerät aufzuprägen und/oder von diesem Signale zu erfassen.

Dafür läuft auf einer Simulationsumgebung das Softwaremodell einer Testumgebung, bei einem Kraftfahrzeug z.B. die Simulation einer Fahrt. Simulierte Ereignisse werden durch elektrische, die Ereignisse repräsentierende Signale an die Ausgabekanäle, z.B. die Pins oder Register der Ausgabekanäle der Schaltung angelegt, um so an das Steuergerät übertragen zu werden und/oder von Steuergerät werden Signale an die Eingabekanäle, z.B. die Pins oder Register der Eingabekanäle der Schaltung angelegt, um so erfasst und in der Simulationsumgebung verarbeitet werden zu können. So kann ein Steuergerät in einer simulierten Umgebung betrieben werden, als wenn es tatsächlich in der echten Umgebung betrieben würde.

Die Simulationsumgebung oder kurz der Simulator wird z.B. gebildet durch ein Echtzeitrechnersystem mit wenigstens einem Prozessor, welcher das Softwaremodell abarbeitet. Beispielsweise kann das Modell durch eine echtzeitfähige Software bzw. eine Vielzahl zusammenwirkender Softwaretools bereitgestellt werden, die vorzugsweise ein grafisches Benutzerinterface aufweist und besonders bevorzugt mittels Softwareobjekten programmiert wird. Die Software kann MATLAB, Simulink oder auch RTI (Real-Time-Interface) der Anmelderin, welche z.B. ein Verbindungsglied zu Simulink bildet, umfassen. Softwareobjekte werden in vorgenannten Fällen z.B. grafisch als Block programmiert, insbesondere hierarchisch. Eine Simulationsumgebung ist jedoch nicht auf die Verwendung dieser jeweils beispielhaft genannten Software beschränkt. Das Softwaremodell ist entweder direkt nach Programmierung oder nach Codegenerierung und Compilierung auf der Simulationsumgebung lauffähig.

Neben der Prozessorschaltung, die den wenigstens einen Prozessor umfasst, umfasst die Simulationsumgebung häufig mindestens eine mit der Prozessorschaltung in Verbindung stehende I/O-Schaltung, welche die genannten Ein-/Ausgabekanäle aufweist. Es kann auch vorgesehen sein, dass wenigstens eine solche I/O-Schaltung, welche Ein- und/oder Ausgabekanäle umfasst, mit einer Schaltung umfassend einen programmierbaren Logikbaustein, insbesondere einem Field Programmable Gate Array (FPGA), in Verbindung steht, um Signale von dieser zu erhalten oder an diese bereitzustellen. Die FPGA-Schaltung ihrerseits kann mit der Prozessorschaltung verbunden sein, so dass das Simulationsmodell teilweise auf der FPGA-Schaltung und teilweise auf der Prozessorschaltung ausgeführt werden kann. Die Ein-/Ausgabekanäle können umschaltbare Abtastraten aufweisen, so dass beispielsweise schnell veränderliche Signale häufiger gemessen werden können als sich langsam ändernde Signale. Eine Abtastrate f kann auch in Form einer über T=1/f korrespondieren Abtastperiode T ausgedrückt werden.

Ein Echtzeitrechnersystem unterscheidet sich insbesondere dadurch von handelsüblichen Computersystemen, dass eine vorgegebene Latenz nicht überschritten wird, beispielsweise zwischen dem Eingang eines geänderten Sensorsignals und der daraus resultierenden Reaktion, wie der Ausgabe eines geänderten Ansteuersignals. Je nach zu simulierendem System kann dabei eine maximale Latenz von beispielsweise 1 Millisekunde oder kürzer erforderlich sein. Insbesondere eine Simulation des Antriebs eines elektrischen Fahrzeugs (E-Drive) bzw. für eine Simulation von Leistungselektronik stellen hohe Anforderungen an die Schnelligkeit des Regelkreises, insbesondere mit maximal zulässigen Latenzen im Bereich von Mikrosekunden, so dass Echtzeitsimulationen häufig nicht mehr von reinen Prozessormodellen und prozessorgesteuerten I/O Kanälen abgedeckt werden, sondern die zeitkritischen Modellteile auf einer frei programmierbaren FPGA-Schaltung ausgeführt werden. Vorzugsweise ist die FPGA-Schaltung dabei so ausgestaltet, dass verschiedene I/O-Schaltung modular mit ihr verbunden werden können.

Verbindungen können durch direkten Anschluss oder auch über Schnittstellen, insbesondere Standard-Schnittstellen, einen Bus oder Netzwerkanbindung bereitgestellt werden. In der vorgenannten bevorzugten Anwendung, aber auch allgemein bei anderen möglichen Anwendungen kann die Anforderung auftreten, dass mehrere elektrische Signale gleichzeitig über mehrere Kanäle der I/O-Schaltung ausgegeben werden müssen und/oder dass mehrere Signale nach einer Erfassung über mehrere Kanäle gleichzeitig weiterverarbeitet werden müssen. Problematisch ist hierbei, dass auch bei Kanälen gleicher Art und Funktion unterschiedliche Latenzen bzw. Signallaufzeiten auftreten können, weil selbst funktionsidentische elektrische Schaltkreise z.B. aufgrund von Serienstreuung bei der Herstellung, keine identischen Latenzen aufweisen. Grundsätzlich sind verschiedene Maßnahmen bekannt, um an den Pins (den physikalischen Anschlussstellen der Kanäle) oder Registern/Speichern von mehreren Ausgabekanälen nach Durchlaufen der Kanalfunktion, z.B. einer Digital-Analog-Wandlung, Signale gleichzeitig zur Verfügung zu stellen, so dass synchron an den Pins/Registern mehrerer Eingangskanäle anliegende Signale auch nach Durchlaufen der Kanalfunktion, wie z.B. einer Analog-Digital-Wandlung die resultierenden Signale synchron für eine Weiterverarbeitung bereit zu stellen. Beispielsweise können die einzelnen Kanäle bei der Fertigung vermessen und die ermittelten Latenzen für eine Kompensation gespeichert werden, wie dies in der EP 3224325 A1 beschrieben ist.

Wird es allerdings in einer Anwendung erforderlich, zwischen verschiedenen Abtastraten eines Eingabe- oder Ausgabe-Kanals umzuschalten, so geht die Synchronität zwischen den verschiedenen Kanälen nach dem Stand der Technik verloren, und aufgenommene Daten der verschiedenen Kanäle weisen keine gleichbleibende zeitliche Beziehung auf. Ein bisher ungelöstes Problem besteht also insbesondere dann, wenn Abtastperiode und Offset sowohl zum Zeitpunkt der Initialisierung des Simulators als auch zur Laufzeit veränderlich sein sollen - unter Beibehaltung der Synchronität für alle Kanäle mit identischen Abtastperioden und Offsets.

Die Druckschrift WO 99/66377 A2 offenbart ein bekanntes Verfahren zur zeitlich synchronisierten Eingabe von Signalen mit wählbarer Abtastrate an einer Gruppe von Eingabekanälen einer elektronischen Schaltung.

Vor diesem Hintergrund besteht die Aufgabe der Erfindung darin, ein Verfahren und eine Vorrichtung anzugeben, welche den Stand der Technik weiterbilden und vorzugsweise ein die Synchronität erhaltendes Umschalten der Abtastperioden zur Laufzeit eines Simulators ermöglichen.

Die Aufgabe wird durch ein Verfahren zur zeitlich synchronisierten Ein- und/oder Ausgabe von Signalen mit wählbarer Abtastrate an einer Gruppe von Ein- und/oder Ausgabekanälen mit den Merkmalen von Anspruch 1 und Vorrichtungen mit den Merkmalen von Ansprüchen 11 und 12 gelöst. Vorteilhafte Ausgestaltungen der Erfindung sind Gegenstand von abhängigen Unteransprüchen.

Es wird also ein computerimplementiertes Verfahren zur zeitlich synchronisierten Ein- und/oder Ausgabe von Signalen mit wählbarer Abtastrate an einer Gruppe von Ein- und/oder Ausgabekanälen einer elektronischen Schaltung bereitgestellt, wobei die elektronische Schaltung mindestens zwei Eingabekanäle und/oder mindestens zwei Ausgabekanäle, einen Taktgeber und einen Zähler umfasst, wobei ein Kanal Signale mit einer vorgegebenen Abtastperiode verarbeitet, die vorzugsweise durch eine Anzahl von Takten des Taktgebers bestimmt ist. Erfindungsgemäß umfasst das Verfahren die aufeinanderfolgenden Schritte:
a. Konfigurieren jedes Kanals der Gruppe mit einer Standardabtastperiode,
b. Synchrones Starten aller Kanäle der Gruppe mit der Standardabtastperiode, wobei mit dem Starten eines Kanals insbesondere ein Beginn der Ein- oder Ausgabe von Signalen auf diesem Kanal gemeint ist,
c. Erfassen einer Vorgabe für eine geänderte Abtastperiode *T_{Periode}* eines ersten Kanals der Gruppe, wobei das Erfassen insbesondere durch einen mit der elektronischen Schaltung verbundenen Prozessor oder programmierbaren Logikbaustein erfolgt,
d. Erfassen eines aktuellen Zählerwerts *T_{Zähler},* wobei der aktuelle Zählerwert vorzugsweise gleichzeitig mit oder direkt nach Eingang der Vorgabe erfasst wird,
e. Konfigurieren des ersten Kanals mit der geänderten Abtastperiode,
f. Ermitteln einer Wartezeit von *T_{Warte}* Takten gemäß *T_{Warte}* = *T_{Periode} - mod*(*T_{Zähler}, T_{Periode}*), wobei *mod*(*T_{Zähler}, T_{Periode}*) den Divisionsrest aus aktuellem Zählerwert und geänderter Abtastperiode bezeichnet, und
g. Starten des ersten Kanals nach der Wartezeit *T_{Warte},* wobei das Starten insbesondere unverzüglich erfolgt, sobald die Wartezeit abgelaufen ist.

Die Erfindung hat den Vorteil, dass in einer mehrkanaligen I/O-Schaltung die Abtastrate eines Kanals unter Beibehaltung der Synchronität geändert werden kann, ohne dass andere Kanäle gleichermaßen verstellt werden müssen. Alle Kanäle mit einer vorgegebenen Abtastperiode oder auch mit einem Vielfachen dieser Periode als Abtastrate bleiben ohne weiteres synchron. Das erfindungsgemäße Verfahren zur Synchronisation kann prinzipiell mit beliebigen I/O-Boards umgesetzt werden, insbesondere wenn die Schaltung des I/O Boards in einem FPGA implementiert ist.

Hierbei ist auch nicht erforderlich, ein unter dem Begriff Strobing bekanntes Verfahren anzuwenden, bei dem vorher in Register übertragene Werte für die Abtastperiode durch ein Strobe-Signal für mehrere Kanäle synchron übernommen werden. Dadurch hat ein erfindungsgemäßes Verfahren eine Vielzahl von Vorteilen:
i. Synchronität verschiedener Kanäle, auch wenn die Kanäle zu unterschiedlichen Zeiten auf dieselbe Abtastrate und Versatz bzw. Offset gesetzt wurden.
ii. Auch verschiedene Kanäle, deren Abtastperioden in einem ganzzahligen Verhältnis stehen, sind automatisch untereinander synchron.
iii. Die Handhabung im Modell ist vereinfacht: Anders als beim Strobing müssen die Raten für unveränderte Kanäle nicht erneut gesetzt werden.
iv. Bei Einstellung von identischen Raten oder vielfachen Raten gibt es keine falsche Zwischenperiode wie beim Strobing.
v. Schnellere Ratenänderungen möglich: Es erfolgt ein reines Setzen der Raten, optional eines zusätzlichen Versatzes, ohne den zusätzlichen Aufwand des Strobings.

Bevorzugt kann die Verarbeitung von Signalen durch einen Kanal um einen durch eine Anzahl von Takten des Taktgebers bestimmten Versatz verzögert werden, und der Schritt des Erfassens einer Vorgabe für eine geänderte Abtastperiode umfasst zusätzlich das Erfassen eine Vorgabe für einen geänderten Versatz *T_{Versatz},* wobei der geänderte Versatz bei der Ermittlung der Wartezeit gemäß *T_{Warte}* = *T_{Periode} - mod*(*T_{Zähler}, T_{Periode}*) *+ T_{Versatz}* berücksichtigt wird, und wobei *T_{Versatz}* = 0 gesetzt wird, falls kein geänderter Versatz erfasst wurde.

Ein Versatz bzw. Offset bezeichnet insbesondere eine konstante Verschiebung der Mess- bzw. Samplezeitpunkts. In der bevorzugten Form ermöglicht die Erfindung weiterhin eine synchrone Offsetveränderung zur Laufzeit auch mit nicht äquidistanten Offsets. Darüber hinaus werden neue Anwendungen ermöglicht: Abtastratenadaptive Anwendungen und Anwendungen mit adaptiven Abtastoffsets (adaptives Interleaving) sind unter Beibehaltung der Synchronität realisierbar. Sollen z.B. Spektren per Fouriertransformation (FFT) aus Analogwerten berechnet werden, muss die Abtastung sowohl exakt äquidistant als auch in der benötigten Abtastrate erfolgen. Wenn Signale erfasst werden sollen, deren Änderungsrate zu hoch für die minimal mögliche Wandlungsdauer ist, können mittels der Erfindung mehrere Kanäle mit unterschiedlichen Offsets parallel aufzeichnen und anschließend kombiniert verarbeitet werden:
In einer bevorzugten Ausführungsform der Erfindung empfangen mindestens zwei Eingabekanäle dasselbe Signal, wobei die mindestens zwei Eingabekanäle mit derselben Abtastperiode, insbesondere der kürzesten möglichen Abtastperiode, und einem ersten konstanten Versatz zwischen benachbarten Kanälen betrieben werden. Bei Erfüllung einer Auslösebedingung wird ein neuer konstanter Versatz eingestellt, insbesondere die Hälfte des ersten konstanten Versatzes. Insbesondere ist die Auslösebedingung erfüllt, wenn die Differenz zwischen zwei aufeinanderfolgende Messwerte mindestens eines der Eingangskanäle einen vorgegebenen Schwellenwert überschreitet.

In einer weiteren bevorzugten Ausführungsform der Erfindung wird ein Eingabekanal mit einer ersten Abtastperiode betrieben, und bei Erfüllung einer Auslösebedingung wird der Eingabekanal auf eine zweite Abtastperiode konfiguriert, insbesondere eine kürzere Abtastperiode. Die Auslösebedingung ist vorzugsweise erfüllt, wenn die Differenz zwischen zwei aufeinanderfolgende Messwerte mindestens eines der Eingangskanäle einen vorgegebenen Schwellenwert überschreitet.

Wenn die mindestens zwei Eingabekanäle und/oder mindestens zwei Ausgabekanäle bzw. die auf diesen Kanälen verbauten Wandlerbausteine für die Verarbeitung eines Signals eine Wandlungsdauer *Tₘᵢₙ* von mehr als einem Takt benötigen, wird vorzugsweise die Wartezeit gemäß *T_{Warte}* = *T_{Warte} + T_{Periode}* um eine geänderte Abtastperiode verlängert, falls die Zeitdifferenz zwischen dem Startzeitpunkt *T_{Zähler} + T_{Warte}* mit geänderter Abtastperiode und dem Zeitpunkt *t_{Sample}* des Beginns der letzten Verarbeitung eines Signals gemäß *T_{Zähler} + T_{Warte} - t_{Sample} < T_{Min}* die Wandlungsdauer *T_{Min}* unterschreiten würde. Je nach Wandlungsdauer kann die Wartezeit auch um eine Vielzahl der neuen Abtastperioden verlängert werden.

Besonders bevorzugt ist die benötigte Wandlungsdauer *T_{Min}* eines Kanals in einem Speicher hinterlegt, der bei einer Änderung der Abtastperiode für den Kanal ausgelesen wird, und die Wartezeit wird anhand der ausgelesen Wandlungsdauer verlängert. Insbesondere wird die Wartezeit gemäß *T_{Warte}* = *T_{Warte}* + *n · T_{Periode}* um eine Vielzahl *n >* 1 von Perioden verlängert. Der im Speicher hinterlegte Wert kann anhand des Typs des Wandlerbausteins beispielsweise aus einem Datenblatt oder durch Ausmessen des individuellen Kanals ermittelt werden.

Ausgehend vom Zählerwert zum Startzeitpunkt der Berechnung kann also über *T_{Zähler} + T_{Warte}* der Zeitpunkt ermittelt werden, zu dem die neue Periode erstmalig aktiv würde. Vorzugsweise wird beim Samplen bzw. Erfassen eines Eingabewerts der aktuelle Zählerwert des Samplezeitpunkts als *t_{Sample}* gespeichert, so dass nach der Berechnung der Wartezeit einfach überprüft werden kann, ob die letzte Wandlung vor dem Umschalten der Abtastrate bereits abgeschlossen ist. Andernfalls wird der Beginn der Erfassung mit neuer Abtastperiode um eine oder mehrere ganze neue Abtastperioden verzögert, so dass die Synchronität der Werte aller Kanäle mit gleicher Abtastperiode sichergestellt ist. Auch andere Verzögerungen, wie beispielsweise eine lange Dauer der Berechnung einer neuen Wartezeit, können durch ein entsprechendes Verzögern um eine oder mehrere neue Abtastperioden berücksichtigt werden.

Wenn die elektronische Schaltung mindestens zwei Teilschaltungen umfasst, welche jeweils mindestens einen Eingabekanal und/oder mindestens einen Ausgabekanal, eine Taktleitung zu einer anderen Teilschaltung oder einen eigenen Taktgeber und einen Zähler aufweisen, umfasst der Schritt eines Synchronen Startens aller Kanäle der Gruppe mit der Standardabtastperiode bevorzugt eine vorherige Synchronisation der eigenen Taktgeber und Zähler der Teilschaltungen, so dass alle Kanäle der Gruppe unabhängig von ihrer Anordnung auf einer Teilschaltung synchron sind. Verfahren zum Synchronisieren von Zählern sind an sich bekannt; beispielsweise können bei mehreren verbundenen Teilschaltungen eigene Taktleitungen vorgesehen sein, über die ein Taktgeber einer Teilschaltung als Master den Takt für alle Teilschaltungen vorgibt. Dann haben alle Teilschaltungen denselben Takt mit exakt derselben Frequenz und bleiben beliebig lange zueinander synchron. Wenn jede Teilschaltung einen Taktgeber wie insbesondere einen Quarzkristall aufweist, können verschiedene an sich bekannte Verfahren zur Synchronisation der Taktgeber eingesetzt werden, um eine eventuell auftretende Frequenzdrift zu korrigieren.

Die Erfindung betrifft ferner ein Echtzeitrechnersystem, umfassend eine Schnittstellenschaltung mit einer Gruppe von Ein- und/oder Ausgabekanälen, wobei die Schnittstellenschaltung mindestens zwei Eingabekanäle und/oder mindestens zwei Ausgabekanäle, einen Taktgeber und einen Zähler umfasst, wobei ein Kanal Signale mit einer durch eine Anzahl von Takten des Taktgebers bestimmten Abtastperiode verarbeitet, und wobei die Verarbeitung von Signalen durch einen Kanal um einen durch eine Anzahl von Takten des Taktgebers bestimmten Versatz verzögert werden kann. Das Echtzeitrechnersystem umfasst weiterhin einen Prozessor und einen programmierbaren Logikbaustein, wobei der Prozessor mit dem programmierbaren Logikbaustein verbunden ist, wobei der programmierbare Logikbaustein mit der Schnittstellenschaltung verbunden ist, und wobei auf einem nichtflüchtigen Speicher des Echtzeitrechnersystems Instruktionen und/oder ein Bitstrom zur Durchführung eines erfindungsgemäßen Verfahrens hinterlegt sind.

Ferner betrifft die Erfindung eine Schnittstellenschaltung umfassend eine Gruppe von Ein- und/oder Ausgabekanälen aus mindestens zwei Eingabekanälen und/oder mindestens zwei Ausgabekanälen, wobei die Schnittstellenschaltung ferner einen Taktgeber, einen Zähler, einen programmierbaren Logikbaustein und einen mit diesem verbundenen nichtflüchtigen Speicher umfasst, wobei ein Kanal Signale mit einer durch eine Anzahl von Takten des Taktgebers bestimmten Abtastperiode verarbeitet, und wobei die Verarbeitung von Signalen durch einen Kanal um einen durch eine Anzahl von Takten des Taktgebers bestimmten Versatz verzögert werden kann. Auf dem nichtflüchtigen Speicher ist ein Bitstrom für den programmierbaren Logikbaustein hinterlegt ist, welcher den programmierbaren Logikbaustein zur Durchführung eines erfindungsgemäßen Verfahrens einrichtet.

Vorzugsweise umfasst der Bitstrom des programmierbaren Logikbaustein eine Teilkonfiguration, welche eine Berechnung des Divisionsrest durchführt, wobei mindestens zwei Kanäle der mindestens zwei Eingabe- und/oder Ausgabekanäle eine gemeinsame Teilkonfiguration für die Berechnung des Divisionsrests verwenden. Dies ermöglicht eine Umschaltung der Abtastperioden mit einem verringerten Ressourcenbedarf auf dem FPGA.

Alternativ ist es bevorzugt, wenn der Bitstrom des programmierbaren Logikbaustein eine Teilkonfiguration umfasst, welche eine Berechnung des Divisionsrest durchführt, wobei die verschiedenen möglichen Abtastperioden vordefiniert sind, und wobei bei der Erstellung des Bitstroms die Breite des Zählers nach Maßgabe der möglichen Abtastperioden gewählt wird. Indem der Maximalwert des Zählers als kleinstes gemeinsames Vielfaches der möglichen Abtastperioden gewählt, ist ein Überlauf des Zählers unproblematisch, so dass ein Zähler mit einer geringeren Breite verwendet werden kann.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Abmessungen sind nicht maßstäblich und weisen, sofern nicht anders angegeben, auch keine ableitbaren geometrischen Relationen zueinander auf.

Darin zeigt:
- Figur 1: eine schematische Ansicht einer beispielgemäßen Hardware-in-the-Loop-Testumgebung,
- Figur 2: eine schematische Ansicht eines Simulators, der synchronisierte I/O-Module bzw. Teilschaltungen und synchronisierte Ein- und Ausgabekanäle umfasst,
- Figur 3: einen schematischen Ablaufplan eines erfindungsgemäßen Verfahrens,
- Figur 4: ein Diagramm des zeitlichen Verlaufs bei einem Umschalten der Abtastperiode,
- Figur 5: eine schematische Darstellung eines beispielhaften Simulationsmodells,
- Figur 6a: eine schematische Ansicht eines ersten Ausführungsbeispiels einer Benutzeroberfläche, die eine Änderung von Abtastperiode und optionalen Versatz in einem Simulationsmodell ermöglicht, und
- Figur 6b: eine schematische Darstellung eines zweiten Ausführungsbeispiels einer Benutzeroberfläche, die zusätzlich mit einem Signal die Zeit angibt, in der eine anliegende neue Abtastrate oder Offset aktiv wird.

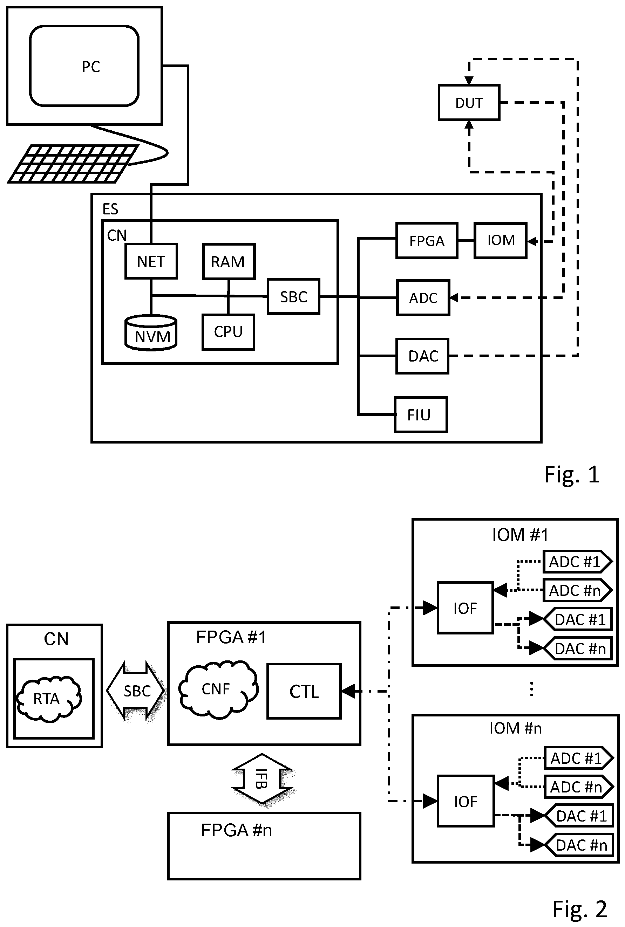

In Figur 1 ist schematisch eine beispielgemäße Hardware-in-the-Loop-Testumgebung mit einem Bedienrechner PC, einem Simulator ES und einem zu testenden Steuergerät DUT dargestellt. Der Bedienrechner PC kann als ein handelsüblicher Personal Computer mit Bildschirm, Eingabegeräten und einer oder mehreren Netzwerkschnittstellen ausgestaltet sein.

Der echtzeitfähige Simulator ES umfasst einen Rechenknoten CN, der über eine Netzwerkschnittstelle NET mit dem Bedienrechner PC verbunden ist. Der Rechenknoten CN weist mindestens einen Prozessor CPU, insbesondere einen Mehrkernprozessor, einen Arbeitsspeicher RAM und einen nichtflüchtigen Speicher NVM auf, auf dem vorzugsweise ein Betriebssystem und/oder ein Bootloader hinterlegt sind. Über einen Hochgeschwindigkeitsbus SBC bzw. einen entsprechenden Controller sind ein Logikboard mit einem programmierbaren Logikbaustein FPGA, zwei I/O-Schaltungen ADC, DAC und eine Fehlersimulationsschaltung FIU mit dem Rechenknoten verbunden. Der programmierbare Logikbaustein FPGA ist bevorzugt frei programmierbar und kann gemäß der vorliegenden Erfindung konfiguriert werden. Es kann auch vorgesehen sein, dass der Simulator ES mehrere Logikboards bzw. mehrere programmierbare Logikbausteine FPGA auf einem Logikboard aufweist. Das Logikboard weist vorzugsweise einen oder mehrere Steckplätze für I/O-Module auf. Dargestellt ist ein I/O-Modul IOM, welches mit dem zu testenden Steuergerät DUT verbunden ist und beispielsweise digitale Eingangs- und Ausgangssignale mit diesem austauschen kann. Die I/O-Schaltung ADC weist einen oder mehrere Analog-Digitalwandler auf, der oder die analoge Signale des zu testenden Steuergerät DUT empfängt. Über die I/O-Schaltung DAC, welche einen oder mehrere Digital-Analog-Wandler aufweist, kann der Simulator ES analoge Signale an das zu testende Steuergerät DUT ausgeben. Die Fehlersimulationsschaltung FIU kann angeschlossene Geräte mit definierten elektrischen Fehlern beaufschlagt, wie beispielsweise einen Kurzschluss zweier Kanäle.

Frei programmierbare Logikbausteine FPGA werden insbesondere für Anwendungsbereiche wie E-Drive und Leistungselektronik eingesetzt, weil dort besonders schnelle Regelkreise auftreten. Zweckmäßigerweise weisen Logikboards mit einem solchen FPGA mehrere Steckplätze für I/O-Module auf; beispielsweise bietet dSPACE das DS6601 FPGA Base Board mit fünf Steckplätzen an, die mit unterschiedlichen I/O-Modulen bestückt werden können. Eine bestehende Testumgebung kann durch den Einbau eines neuen I/O-Moduls beispielsweise um eine Analog-Digital-Wandlung mit einer hohen Auflösung erweitert werden. I/O-Module können auch verschiedenartige Kanäle aufweisen, wie beispielsweise das DS6651 Multi-I/O Module, welches über jeweils sechs analoge Eingangs- und Ausgangskanäle mit 16 bit Auflösung und 16 digitale Ein- und Ausgangskanäle verfügt. Werden fünf DS6651 Module an einem Logikboard betrieben, müssen jeweils bis zu 30 analoge Eingangskanäle und 30 analoge Ausgangskanäle synchron arbeiten. Unter synchron arbeiten soll vorzugsweise verstanden werden, dass alle Kanäle Eingangs- und/oder Ausgangskanäle auf dieselbe Taktflanke eines gemeinsamen Takts genau abtasten (bzw. die Wandlung anstoßen) und somit beispielsweise eine Zeitauflösung von 8ns bieten.

Indem eine synchrone Verstellung der Abtastraten mit einem erfindungsgemäßen Verfahren erfolgt, ist es nicht erforderlich, mit einer einzigen festen Abtastrate zu arbeiten, sondern die Abtastrate und zusätzlich auch ein Offset bzw. Versatz können beliebig oft verstellt werden, wobei trotzdem alle verwendeten Kanäle der I/O Module an einem FPGA Base Board wieder auf den Takt genau synchron arbeiten, sobald zu einem späteren Zeitpunkt wieder dieselbe Abtastrate und derselbe Offset für diese verwendeten Kanäle eingestellt werden.

Gleichzeitig erfolgt die Abtastraten- und Offsetänderung schneller und ist somit hochvariabel, wodurch abtastratenadaptive Anwendungen und Anwendungen mit adaptiven Abtastoffsets (adaptives Interleaving) unter Beibehaltung der Synchronität realisierbar sind. Interleaving bezeichnet ein Messverfahren, bei dem mehrere Kanäle dasselbe Signal mit verschiedenen Offsets aufnehmen, was bei kurzen äquidistanten Offsets eine zeitlich höheraufgelöste Messung des Signals erlaubt. Während typische 16-Bit ADCs eine minimale Abtastperiode bzw. Wandlungsdauer von beispielsweise 200ns haben, ist der Offset um einzelne Taktperioden von insbesondere 8ns verschiebbar. Ein DS6601 FPGA Base Board mit fünf DS6651 Modulen ermöglicht eine Abtastsequenz von 30 Messungen in einem Raster bis herab zu 8ns, wodurch bei einer minimalen Abtastperiode von 200ns eine dauerhafte Abtastung mit bis zu 8ns/125MHz unter Verwendung von 25 ADCs möglich ist. Je nach Bedarf kann mit dem erfindungsgemäßen Verfahren der Offset adaptiv verschoben werden. Dies ermöglicht beispielsweise eine Anpassung der Zeitauflösung, indem Vielfache der 8ns als Offsets eingestellt werden. Durch das erfindungsgemäße Verfahren muss eine Messung nicht nach jeder Abtastratenänderung neu gestartet werden. Außerdem sind auch nicht äquidistante Offsets möglich, wodurch z.B. ausgewählte Signalbereiche höher aufgelöst abgetastet werden können als die restlichen.

Figur 2 zeigt eine schematische Ansicht eines Simulators, der synchronisierte I/O-Module bzw. Teilschaltungen und synchronisierte Ein- und Ausgabekanäle umfasst. Auf dem Rechenknoten CN wird eine Echtzeitapplikation RTA ausgeführt, die beispielweise ein weniger zeitkritisches Teilmodell umfasst. Über einen Hochgeschwindigkeitsbus SBC ist ein Logikboard mit einem programmierbaren Logikbaustein FPGA #1 angebunden, der zumindest teilweise frei programmiert werden kann. Über einen internen Bus FB des Logikboards können weitere freiprogrammierbare Logikbausteine verbunden sein; hier ist beispielhaft ein zweiter programmierbarer Logikbaustein FPGA #n dargestellt. Zumindest eine erste Partition des Logikbausteins FPGA #1 wird mit einer Konfiguration CNF konfiguriert, die insbesondere ein zeitkritisches Teilmodell umfasst. Die Konfiguration CNF kann insbesondere anhand eines grafischen Modells erstellt sein und zu Beginn einer Simulation aufgespielt werden. Auf einer zweiten Partition kann ein I/O-Bus-Controller CTL implementiert sein, über den verschiedene I/O-Module angebunden sind.

Beispielhaft dargestellt sind ein erstes I/O-Modul IOM #1 und ein zweites I/O-Modul IOM #n, die über den I/O-Bus mit dem frei programmierbaren Logikbaustein FPGA #1 verbunden sind. Auf den I/O-Modulen sind jeweils ein programmierbarer Logikbaustein IOF, zwei Analog-Digital-Konverter ADC #1, ADC #n und zwei Digital-Analog-Konverter DAC #1, DAC #n angeordnet. Wie dargestellt würden die I/O-Module also zwei analoge Eingangs- und zwei analoge Ausgangskanäle bereitstellen. Prinzipiell kann die Anzahl verfügbarer Kanäle durch weitere Bausteine erhöht werden, hier sind der besseren Übersichtlichkeit wegen nur je zwei dargestellt.

In der Figur sind synchronisierte I/O Kanäle durch gleichartige Verbindungslinien dargestellt, wobei zwischen analogen Eingangskanälen ADC (gepunktete Verbindungslinie) und analogen Ausgangskanälen (gestrichelte Verbindungslinie) als zwei eigene Synchronisationsdomänen unterschieden wird. Eine Verbindung zwischen synchronisierten I/O Modulen und dem zentralen Logikbaustein FPGA ist als strichpunktierte Verbindungslinie dargestellt. Prinzipiell können Eingangs- und Ausgangskanäle auch in einer gemeinsamen Synchronisationsdomäne zusammengefasst werden. Sobald die im Folgenden beschriebenen Synchronisationsschritte durchgeführt wurden (insbesondere der vierte Schritt) erfolgt das Abtasten eines analogen Eingangswerts durch den Analog-Digital-Wandler ADC im selben Takt wie die Übergabe des auszugebenden numerischen Werts an den Digital-Analog-Wandler DAC. Man kann dies als Wandler-Synchronität bezeichnen, da die Signale synchron am Wandler anliegen. Es liegt jedoch keine Synchronität an dem Pin vor, über den das zu testende Steuergerät angeschlossen ist. Grund hierfür ist, dass ein auszugebender Wert von dem DAC erst nach einer Wandlungsdauer von z.B. 96ns als analoges Signal am Pin ausgegeben wird. Mit dem erfindungsgemäßen Verfahren lässt sich die Pin-Synchronität einfach dadurch erreichen, dass die durch den Wandlertyp gegebene und somit bekannte Wandlungsdauer als Offset bzw. des jeweiligen Kanals eingestellt wird. Dies ermöglicht die freie Auswahl zwischen Wandler- und Pin-Synchronität.

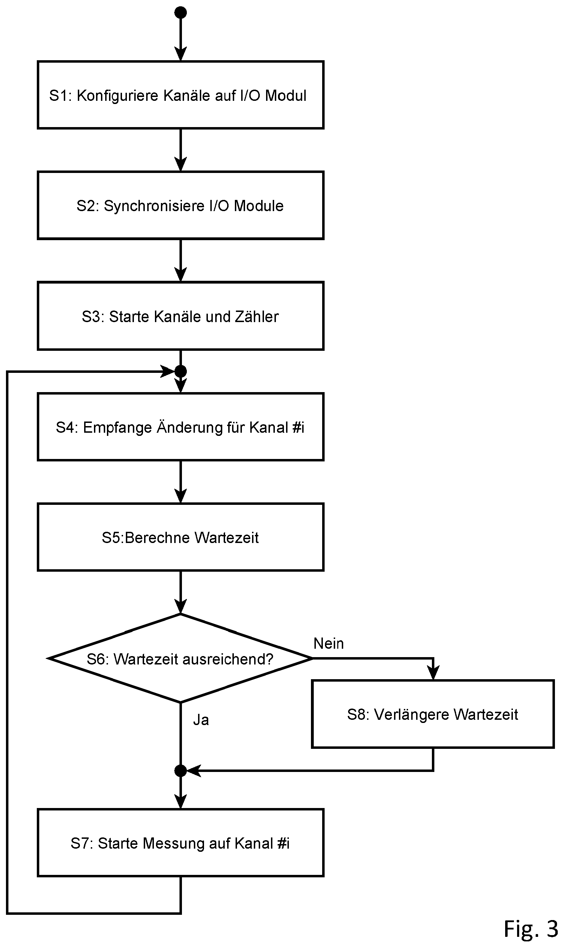

Figur 3 zeigt einen Ablaufplan eines Verfahrens gemäß einer bevorzugten Ausführungsform der Erfindung, bei dem die Synchronisierung der Abtastzeitpunkte aller Analogkanäle in mehreren Schritten erfolgt.

In Schritt S1 (Konfiguriere Kanäle auf I/O Modul), der zweckmäßigerweise von dem auf dem I/O Modul angeordneten Logikbaustein IOF durchgeführt wird, werden alle auf dem Modul angeordneten analogen Eingangs- und/oder Ausgangskanäle mit einem vorgegebenen Anfangswert für die Abtastrate bzw. einer Standardabtastperiode und einem vorgegebenen Anfangswert für den Versatz konfiguriert. Der Anfangswert für den Versatz kann insbesondere 0 sein oder einem für alle Wandler eines Typs konstanten Wert entsprechen. Wenn beispielsweise Analog-Digital-Wandler ADC eines I/O-Moduls länger für die Wandlung benötigt als der Digital-Analog-Wandler DAC des I/O-Moduls, kann die Differenz der Wandlungsdauern als Standardversatz des DAC vorgegeben werden, um Pin-Synchronität zu erreichen. Wenn mehrere I/O-Module mit einem zentralen Logikbaustein FPGA verbunden sind, werden vorzugsweise die Kanäle aller I/O-Module vorkonfiguriert, so dass ein initiales Einstellen der Abtastraten und Offsets an allen ADCs und DACs der Analogkanäle erfolgt. Insbesondere kann es vorgesehen sein, dass nach einem Reset bzw. dem Start eines Simulators die Logikbausteine IOM der I/O Modul hinterlegte Default Settings abrufen und anwenden, wie z.B. die schnellste mit dem jeweiligen Wandler mögliche Abtastratrate und einen Versatz von 0 für alle auf dem I/O-Modul angeordneten Eingangs- und/oder Ausgangskanäle.

In Schritt S2 (Synchronisiere I/O-Module) findet eine Synchronisation aller über den I/O-Bus mit dem zentralen, freiprogrammierbaren Logikbaustein verbundenen I/O-Module statt. Hierbei kann es vorgesehen sein, auch I/O-Module verschiedener Typen bzw. mit unterschiedlicher Kanalausstattung zu synchronisieren. Bevorzugt synchronisieren sich die einzelnen I/O-Module auf den zentralen Logikbaustein FPGA. Beispielweise kann der I/O-Bus als Low Voltage Differential Signalling (LVDS) Schnittstelle mit mehreren Lanes ausgeführt sein. Die Synchronisation mehrerer I/O Module über eine LVDS Anbindung kann so erfolgen, dass nach dem Training der LVDS Strecke die Offsets der einzelnen Lanes zueinander verschoben werden, bis eine synchrone Eintaktung aller Lanes aller I/O-Module vorliegt. Prinzipiell kann auch ein anderes an sich bekanntes Verfahren zum Einsatz kommen, welches eine Synchronisation mehrerer programmierbarer Logikbausteine untereinander ermöglicht.

In Schritt S3 (Starte Kanäle und Zähler) erfolgt ein synchrones Starten aller Analogkanäle mit den konfigurierten Abtastraten und Offsets. Zusätzlich dazu, dass alle Analogkanäle aller I/O Module synchron mit den konfigurierten Abtastraten und Offsets gestartet werden, wird jeweils ein auf dem Logikbaustein IOF jedes I/O Moduls instanziierter Zähler gestartet. Da dieser Zähler die Auflösung der Synchronisierung begrenzt, wird er vorzugsweise mit dem vollen Takt beaufschlagt und zählt also taktgenau. Damit der Zähler nicht vor Ablauf einer vorgegebenen garantierten Laufzeit des Echtzeitsimulators überläuft, verfügt der Zähler vorzugsweise über eine Breite von 56 Bit, was bei einer Taktperiode von 8ns 18,3 Jahren entspricht; prinzipiell kann auch eine größere oder kleinere Breite eingesetzt werden.

In Schritt S4 (Empfange Änderung für Kanal #i) wird eine geänderte Vorgabe für Abtastperiode und/oder Versatz empfangen. Diese kann beispielsweise von einem Benutzer des Simulators über eine weiter unten beschriebene Bedienoberfläche eingegeben werden. Es kann auch vorgesehen sein, dass die Echtzeitanwendung bzw. das Simulationsmodell fest hinterlegte Vorgaben für eine Änderung der Abtastperiode enthält; insbesondere kann bei Erfüllung einer Auslösebedingung die Abtastung mit einer höheren zeitlichen Auflösung erfolgen.

Nun muss der Startzeitpunkt für die Anwendung der neuen Abtastperiode und/oder des neuen Versatzes ermittelt werden, um eine synchrone Abtastung aller Kanäle, die identische Abtastraten und Offsets verwenden, sicherzustellen; dies kann zweckmäßigerweise auf dem Logikbaustein IOF des I/O-Moduls erfolgen.

In Schritt S5 (Berechne Wartezeit) wird für eine neu einzustellende Abtastrate der Divisionsrest *mod*(*T_{Zähler}, T_{Periode}*) aus Zählerwert (Anzahl von Takten) und der neuen Abtastperiode (Vielfaches von Takten) gebildet. Die Differenz aus Abtastperiode und dem Divisionsrest ergibt die Zeit in Takten, die noch zu warten ist, um die Abtastung so zu starten, so dass man derart auf dem Abtastraster liegt, als wäre man schon zum Zeitpunkt 0 mit diesem Abtastraster gestartet. Wenn nur der Versatz *T_{Versatz}* geändert wurde, aber die Abtastperiode gleichbleibt, erhält man also einen Rest von 0. Die Summe aus dieser Differenz und dem als ein Vielfaches von Takten angegebenen Versatz bzw. Offset ergibt die Zeit in Takten, die zu warten ist, bis die Abtastung mit der neuen Rate beginnen soll, wenn zusätzlich ein Offset größer 0 eingestellt wurde. Die Wartezeit *T_{Warte}* in Takten bis zum Starten einer neuen Abtastrate kann somit gemäß ${T}_{Warte} = {T}_{Periode} - mod \left({T}_{Z ä hler}, {T}_{Periode}\right) + {T}_{Versatz}$ berechnet werden.

In Schritt S6 (Wartezeit ausreichend?) wird überprüft, ob die Wartezeit ausreicht, damit der Wandler von Kanal #i den letzten abgetasteten Wert bereits konvertiert hat. Falls dies nicht der Fall ist, die Summe der Zeit seit der letzten Abtastung mit der alten Rate und der berechneten Wartezeit *T_{Warte}* also kleiner als die minimale Wandlungsdauer ist, muss die Wartezeit verlängert werden. Zu diesem Zweck wird in Schritt S8 (Verlängere Wartezeit) gemäß *T_{Warte}* = *T_{Warte} + T_{Periode}* noch eine Periode der neuen Abtastrate aufaddiert. Dies kann iterativ erfolgen, bis *T_{Zähler} + T_{Warte} - t_{Sample} > T_{Min}* gilt, oder es kann direkt eine für den jeweiligen Wandler passende Verlängerung der Wartezeit um mehrere Takte erfolgen.

Wenn die Wartezeit ausreichend war bzw. entsprechend verlängert wurde, erfolgt in Schritt S7 (Starte Messung auf Kanal #i) ein Starten der Messung passend zum Ablauf der Wartezeit. Alle Kanäle mit derselben Abtastperiode messen synchron oder die Messungen haben einen festen vorgegebenen Zeitabstand zueinander. Das Verfahren kann für denselben Kanal oder einen beliebigen anderen Kanal fortgeführt werden, für den eine geänderte Abtastperiode und/oder ein geänderter Versatz empfangen wird.

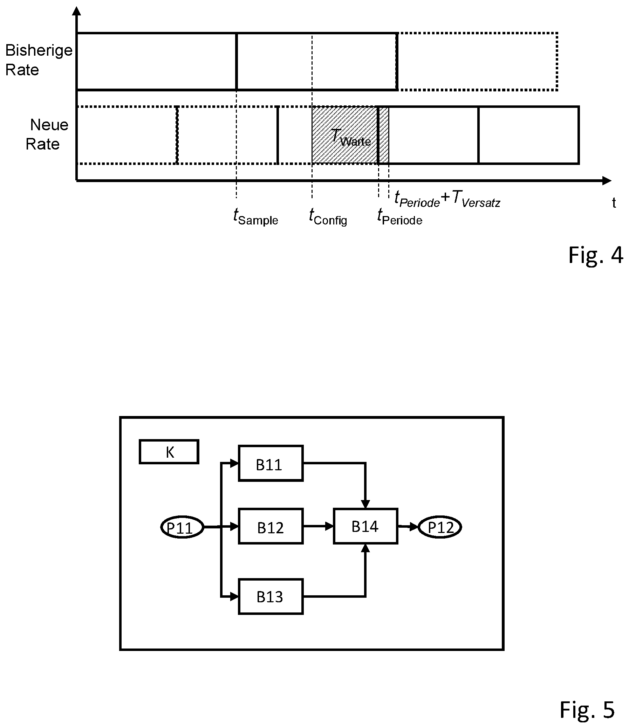

Figur 4 zeigt ein Diagramm des zeitlichen Verlaufs bei einem Umschalten der Abtastperiode, in dem schematisch das Abtastraster einer Messung mit der bisherigen Rate und das Abtastraster einer Messung mit einer neuen Rate bzw. neu eingestellten Abtastperiode und einem gewünschten Versatz zu sehen sind. Senkrechte Striche stellen dabei jeweilige Abtastzeitpunkte dar. Hierbei bezeichnet *t_{Sample}* den Zeitpunkt, an dem die letzte Abtastung eines Signals mit der bisherigen Rate erfolgt ist. Zum Zeitpunkt *t_{Config}* wird eine geänderte Abtastperiode erfasst, beispielsweise weil ein Nutzer eine Messung mit der neuen Rate einstellt. Die gemäß der obigen Formel berechnete Wartezeit *T_{Warte}* ist als ein schraffiertes Rechteck dargestellt. Als *t_{Periode}* ist der Zeitpunkt dargestellt, ab dem eine Messung mit dem neuen Raster erfolgen könnte. In dem gezeigten Beispiel wurde aber zusätzlich ein Offset *T_{Versatz}* eingestellt, der in einer entsprechend längeren Wartezeit resultiert. Hier wie auch sonst wurde angenommen, dass die Berechnung der Wartezeit instantan erfolgt; eine längere Berechnungszeit könnte aber auch entsprechend einer Wandlungsdauer bei der Wartezeit berücksichtigt werden.

Figur 5 zeigt eine schematische Darstellung eines beispielhaften Simulationsmodells, insbesondere eines auf dem frei programmierbaren Logikbaustein FPGA auszuführenden Teilmodells. Dargestellt sind ein Eingangsport P11, ein Ausgangsport P12, vier Berechnungsblöcke B11, B12, B13, B14 und ein Konfigurationsblock K. Die Blöcke sind durch Signallinien verbunden, über die Daten wie der numerische Wert eines erfassten Eingangssignals ausgetauscht werden. Das dargestellte Simulationsmodell kann beispielsweise auf dem Bedienrechner PC dargestellt und bearbeitet werden. Für eine Echtzeitsimulation wird aus dem Simulationsmodell Code generiert, beispielsweise in einer Hardwarebeschreibungssprache, aus der eine Konfiguration für den Logikbaustein FPGA erzeugt wird. Es kann auch vorgesehen sein, dass das Modell während der Echtzeitsimulation weiter dargestellt wird, um als Benutzeroberfläche für das Anzeigen und Ändern von Werten zu dienen. Alternativ kann auch ein dediziertes Programm zum Anzeigen und Einstellen von Werten während der Simulation eingesetzt werden.

Vorzugsweise gibt es mehrere Möglichkeiten für einen Nutzer des Simulators, eine neue Abtastrate oder einen neuen Offset für einen Kanal einzustellen:
Die geänderte Abtastrate kann bei der Initialisierung der Echtzeitphase eingestellt werden, indem der entsprechende Parameter des Simulationsmodells angepasst wird und anschließend die Codegenerierung für die FPGA-Konfiguration erfolgt. Bevorzugt wird der neue Wert für die Abtastperiode nach der Synchronisation der I/O Module (Schritt S2) in den Logikbaustein IOM des I/O Moduls übertragen.

Alternativ kann es auch vorgesehen, die geänderte Abtastperiode an der Repräsentanz der FPGA Konfiguration in dem Modellierungstool für eine prozessorbasierte Echtzeitapplikation einzustellen. Der neue Wert wird während der Initialisierung der Echtzeitapplikation vom Prozessor über das Logikboard in den Logikbaustein IOM des I/O Moduls übertragen.

Während der Laufzeit der Echtzeitphase kann ein neuer Wert für die Abtastperiode und/oder ein neuer Wert für den Versatz über einen Port z.B. an einem Modelblock als Repräsentanz des Analogkanals eingestellt werden. Vorzugsweise wird der neue Wert für die Abtastperiode von dem frei programmierbaren Logikbaustein FPGA über ein Registerinterface vom Prozessormodell empfangen. Dann ist der Wert nicht nur vom FPGA Modell, sondern auch vom Prozessormodell und somit auch über Steuerungswerkzeuge bzw. -programme oder Automationsschnittstellen wie die generische Simulatorschnittstelle XIL API (Application Programming Interface) zur Laufzeit verstellbar.

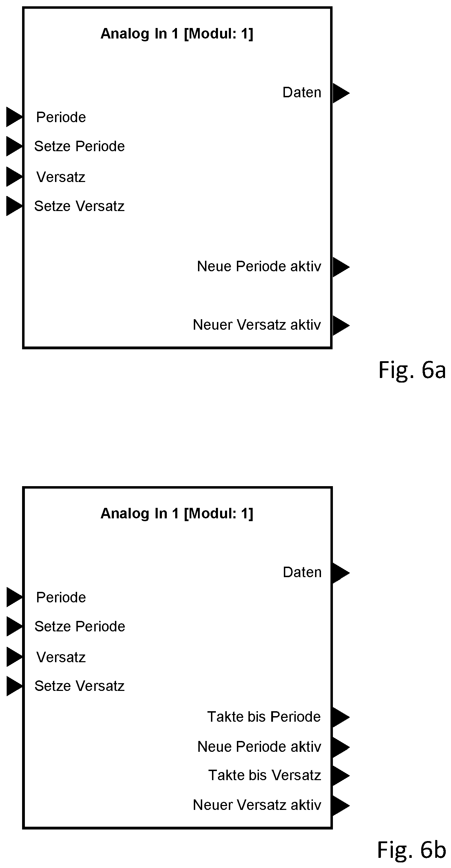

Figur 6a zeigt eine schematische Ansicht eines ersten Ausführungsbeispiels einer Benutzeroberfläche, die eine Änderung von Abtastperiode und optionalen Versatz in einem Simulationsmodell ermöglicht. So kann beispielsweise ein Bezeichner wie Analog In1 [Modul: 1] angegeben sein, der den Eingabe- bzw. Ausgabekanal identifiziert, bei dem die geänderte Abtastperiode und/oder der geänderte Versatz eingestellt wird. Der dargestellte Block umfasst Eingänge zum Empfangen einer neuen Periode und eines neuen Versatzes. Daneben kann über die Eingänge Setze Periode und Setze Versatz jeweils ein Startsignal für das Einstellen einer neuen Abtastperiode bzw. eines neuen Versatzes empfangen werden. Über den Ausgang Daten können die vom Analog-Digital-Wandler gemessenen Werte des Eingangssignals an weitere Teile des Modells übergeben werden. Zwei weitere Ausgänge Neue Periode aktiv bzw. Neuer Versatz aktiv geben ein Signal aus, sobald eine neue Konfiguration gesetzt wurde und somit die Abtastung mit der neuen Abtastperiode und/oder dem neuen Versatz erfolgt.

Figur 6b zeigt eine schematische Darstellung eines zweiten Ausführungsbeispiels einer Benutzeroberfläche, die dem beschriebenen Block entspricht, aber zusätzlich mit einem Signal die Zeit angibt, in der eine anliegende neue Abtastrate oder ein neuer Offset aktiv würde. Indem entsprechender Mechanismus in einem VHDL Framework für den frei programmierbaren Logikbaustein FPGA für jeden Kanal implementiert wird, bieten diese Kanäle einem Benutzer verschiedene Möglichkeiten: So kann an einem Block im FPGA Modell, der den entsprechenden Kanal repräsentiert, über einen Port dieses Blocks genau signalisiert werden, wann eine neu einzustellende Abtastrate im I/O-Modul übernommen wurde. Dies ermöglicht es, im FPGA Modell bzw. Simulationsmodell direkt darauf zu reagieren. An einem weiteren Port kann außerdem signalisiert werden, in wieviel Takten eine neu einzustellende Abtastrate übernommen würde. Vorzugsweise kann der Block auch eine Checkbox aufweisen, durch die ein Benutzer wählen kann, ob eine Wandler- oder eine Pin-Synchronität zwischen Analog In und Analog Out Kanälen angewendet wird.

Für die Ermittlung eines Divisionsrest ist eine Division bzw. eine Multiplikation mit einem Kehrwert erforderlich, welche in einem programmierbaren Logikbaustein viel Fläche und mehrere Takte Rechenzeit benötigen kann. Beispielweise kann es erforderlich sein, einen Zählerwert mit 56 Bit Breite durch eine 32 Bit Abtastperiode zu teilen bzw. den Divisionrest zu ermitteln, wodurch insbesondere 200ns (25 Takte) bis 30s als Abtastperiode einstellbar sein können. Gemäß verschiedenen bevorzugten Ausführungsformen kann auf die Implementierung einer vollständigen Division verzichtet bzw. der Aufwand verringert werden:
In einer ersten Ausführungsform kann es vorgesehen sein, nur Zweierpotenzen als Abtastperioden zu erlauben. Dann muss man nicht dividieren, sondern nur Shiften, was selbst für die maximale Abtastperiode von 32 Bit nur 1 Takt und nahezu keine Ressourcen benötigt.

In weiteren Ausführungsformen werden beliebige Abtastperioden erlaubt, wodurch eine Division erforderlich ist, wobei der Divider auf verschiedene Weisen optimiert werden kann:
In einer zweiten Ausführungsform wird die Division n-fach parallel instanziiert. Ein Divider ist auch mit Pipelining bei mehreren Kanälen mindestens 1 Takt langsamer pro Kanal als eine parallele Ausführung. In einem Tradeoff zwischen Geschwindigkeit und Verbrauch auf von Ressourcen auf dem programmierbaren Logikbaustein kann man den Divider 1 bis n-fach instanziieren, so dass sich mehrere Kanäle einen Divider teilen.

In einer dritten Ausführungsform erfolgt eine Optimierung des Dividers, um geringere Durchlauflatenz zu erzielen: Da die benötigte Logik und die auftretende Latenz mit abnehmender Anzahl zu bearbeitender Bits abnimmt, wird hier die maximale Laufzeit und somit die oberen Bits des Counters stärker begrenzt. Man kann die Bits des Zählers massiv reduzieren, indem man absichert, dass ein Überlauf des Zählers die Synchronität nicht zerstört.

Hierbei besteht zum einen die Möglichkeit, den maximalen Counter Wert auf das kleinste gemeinsame Vielfache aller einstellbaren Sample Raten zu beschränken. Dies ist sinnvoll, wenn es nur geringe Anzahl möglicher Abtastperioden gibt. Dadurch ist ein Zählerüberlauf ohne Bedeutung, da sich nichts verschiebt, wenn der maximale Counterwert ohne Rest durch alle möglichen Abtastperioden teilbar ist.

Zum anderen besteht die Möglichkeit, für jeden Kanal ein *T*_{KanalüberlaufOffset} (unabhängig vom Offset) zu speichern. Zum Zeitpunkt 0 ist *T*_{KanalüberlaufOffset} = 0.

Für die Berechnung der Wartezeit für eine neue Abtastrate muss dieser *T*_{KanalüberlaufOffset} vorher zusätzlich auf den Counter addiert werden ${T}_{Warte} = \left({T}_{NeuePeriode}-mod\left({T}_{Zähler}+{T}_{KanalüberlaufOffset},{T}_{NeuePeriode}\right)\right) + {T}_{Versatz}$

Zu einer neuen Abtastrate speichert man den Divisionsrest: ${T}_{KanalRest} = mod \left({T}_{MaxZählerWert}+{T}_{KanalüberlaufOffset},{T}_{NeuePeriode}\right)$

Bei jedem Überlauf des Counters wird für jeden Kanal sein *T*_{KanalüberlaufOffset} um *T*_{KanalRest} inkrementiert und anschließend reduziert, damit er nicht selbst überläuft: ${T}_{KanalüberlaufOffset} = mod \left({T}_{KanalüberlaufOffset}+{T}_{KanalRest},{T}_{Period}\right)$

Durch die Erfindung wird ein nachträgliches Verstellen der Abtastrate und des Offsets für Analog-Digital-Wandler (ADC) & Digital-Analog-Wandler (DAC) in einem Echtzeitsystem unter Beibehaltung der Synchronität des Abtastzeitpunktes jeweils aller Kanäle mit identischen Abtastraten und Offset Einstellungen möglich.

## Patentansprüche

1. Verfahren zur zeitlich synchronisierten Ein- und/oder Ausgabe von Signalen mit wählbarer Abtastrate an einer Gruppe von Ein- und/oder Ausgabekanälen einer elektronischen Schaltung, wobei die elektronische Schaltung mindestens zwei Eingabekanäle und/oder mindestens zwei Ausgabekanäle, einen Taktgeber und einen Zähler umfasst, wobei der Zähler mit dem vollen Takt des Taktgebers beaufschlagt wird, wobei ein Kanal Signale mit einer vorgegebenen Abtastperiode verarbeitet, die durch eine Anzahl von Takten des Taktgebers bestimmt ist, wobei die elektronische Schaltung mindestens zwei Teilschaltungen umfasst, welche jeweils mindestens einen Eingabekanal und/oder mindestens einen Ausgabekanal, eine Taktleitung zu einer anderen Teilschaltung oder einen eigenen Taktgeber und einen Zähler aufweisen, das Verfahren umfassend die aufeinanderfolgenden Schritte:
a. Konfigurieren jedes Kanals der Gruppe mit einer Standardabtastperiode,
b. Synchrones Starten aller Kanäle der Gruppe mit der Standardabtastperiode, wobei das Synchrone Starten aller Kanäle der Gruppe mit der Standardabtastperiode eine vorherige Synchronisation der eigenen Taktgeber und Zähler der Teilschaltungen umfasst, so dass alle Kanäle der Gruppe unabhängig von ihrer Anordnung auf einer Teilschaltung synchron sind, wobei auch der Zähler gestartet wird,
c. Erfassen einer Vorgabe für eine geänderte Abtastperiode *T_{Periode}* eines ersten Kanals der Gruppe,
d. Erfassen eines aktuellen Zählerwerts *T_{Zähler},*
e. Konfigurieren des ersten Kanals mit der geänderten Abtastperiode,
f. Ermitteln einer Wartezeit von *T_{Warte}* Takten gemäß *T_{Warte}* = *T_{Periode}* - *mod*(*T_{Zähler}, T_{Periode}*), wobei *mod*(*T_{Zähler}, T_{Periode}*) den Divisionsrest aus dem aktuellen Zählerwert *T_{Zähler}* und der geänderten Abtastperiode *T_{Periode}* bezeichnet, und
g. Starten des ersten Kanals nach der Wartezeit *T_{Warte}.*

2. Verfahren nach Anspruch 1, **dadurch gekennzeichnet, dass** die Verarbeitung von Signalen durch einen Kanal um einen durch eine Anzahl von Takten des Taktgebers bestimmten Versatz verzögert wird, dass der Schritt des Erfassens einer Vorgabe für eine geänderte Abtastperiode zusätzlich das Erfassen eine Vorgabe für einen geänderten Versatz *T_{Versatz}* umfasst, und dass der geänderte Versatz bei der Ermittlung der Wartezeit gemäß
*T_{Warte}* = *T_{Periode} - mod*(*T_{Zähler}, T_{Periode}*) *+ T_{Versatz}* berücksichtigt wird, wobei *T_{Versatz}* = 0 gesetzt wird, falls kein geänderter Versatz erfasst wurde.

3. Verfahren nach Anspruch 1 oder 2, **dadurch gekennzeichnet, dass** die mindestens zwei Eingabekanäle und/oder mindestens zwei Ausgabekanäle für die Verarbeitung eines Signals eine Wandlungsdauer *T_{Min}* von mehr als einem Takt benötigen, wobei die Wartezeit gemäß *T_{Warte}* = *T_{Warte} + T_{Periode}* um eine geänderte Abtastperiode verlängert wird, falls die Zeitdifferenz zwischen dem Startzeitpunkt *T_{Zähler} + T_{Warte}* mit geänderter Abtastperiode und dem Zeitpunkt *t_{Sample}* des Beginns der letzten Verarbeitung eines Signals gemäß *T_{Zähler} + T_{Warte} - t_{Sample} < T_{Min}* die Wandlungsdauer *T_{Min}* unterschreiten würde.

4. Verfahren nach Anspruch 3, **dadurch gekennzeichnet, dass** die benötigte Wandlungsdauer *T_{Min}* eines Kanals in einem Speicher hinterlegt ist, der bei einer Änderung der Abtastperiode für den Kanal ausgelesen wird, und wobei die Wartezeit anhand der ausgelesen Wandlungsdauer verlängert wird, insbesondere die Wartezeit gemäß *T_{Warte}* = *T_{Warte}* + *n · T_{Periode}* um eine Vielzahl *n >* 1 von Perioden verlängert wird.

5. Verfahren nach einem der vorhergehenden Ansprüche, **dadurch gekennzeichnet, dass** mindestens zwei Eingabekanäle dasselbe Signal empfangen, wobei die mindestens zwei Eingabekanäle mit derselben Abtastperiode, insbesondere der kürzesten möglichen Abtastperiode, und einem ersten konstanten Versatz zwischen benachbarten Kanälen betrieben, und dass bei Erfüllung einer Auslösebedingung ein neuer konstanter Versatz eingestellt wird, insbesondere die Hälfte des ersten konstanten Versatzes.

6. Verfahren nach einem der vorhergehenden Ansprüche, **dadurch gekennzeichnet, dass** ein Eingabekanal mit einer ersten Abtastperiode betrieben wird und bei Erfüllung einer Auslösebedingung auf eine zweite Abtastperiode konfiguriert wird, insbesondere eine kürzere Abtastperiode.

7. Verfahren nach einem der vorhergehenden Ansprüche, **dadurch gekennzeichnet, dass** jede Teilschaltung auf einem getrennten FPGA-Baustein angeordnet ist, wobei vorzugsweise eine zentrale Schaltung mit zwei oder mehreren Teilschaltungen verbunden ist, insbesondere der Takt für die Teilschaltungen von dem Taktgeber der zentralen Schaltung an die Teilschaltungen verteilt wird.

8. Verfahren nach einem der vorhergehenden Ansprüche, **dadurch gekennzeichnet, dass** die elektronische Schaltung einen frei programmierbaren FPGA-Baustein aufweist, dessen Konfiguration bei Initialisierung einer Simulation neu geschrieben wird, wobei die Konfiguration des frei programmierbaren FPGA-Bausteins dafür eingerichtet ist, mindestens einen Schritt des erfindungsgemäßen Verfahrens für mindestens einen Kanal auszuführen, vorzugsweise für alle verwendeten Kanäle.

9. Verfahren nach Anspruch 8, **dadurch gekennzeichnet, dass** die elektronische Schaltung mit einem Bediencomputer verbunden ist, auf dem eine grafische Benutzeroberfläche mit einer grafischen Darstellung des zu simulierenden Modells ausgeführt wird, und dass für mindestens einen Kanal ein Kanalobjekt, insbesondere ein Block, in der grafischen Benutzeroberfläche dargestellt wird, vorzugsweise die Konfiguration des frei programmierten FPGA-Bausteins anhand der grafischen Darstellung des zu simulierenden Modells generiert wird.

10. Verfahren nach Anspruch 9, **dadurch gekennzeichnet, dass** das Kanalobjekt dazu eingerichtet ist, über Ports Signale aus dem simulierten Modell zu empfangen und/oder Signale an das simulierte Modell auszugeben, insbesondere einen Port, der taktgenau angibt, wenn der zugeordnete Kanal mit einer neuen Abtastperiode gestartet wurde, und/oder einen Port, der angibt, in wie vielen Takten eine neu eingestellte Abtastrate wirksam wird, und/oder einen Port, über den eine Vorgabe für den Versatz des Kanals um eine Anzahl von Takten empfangen wird.

11. Echtzeitrechnersystem, umfassend eine Schnittstellenschaltung mit einer Gruppe von Ein- und/oder Ausgabekanälen, wobei die Schnittstellenschaltung mindestens zwei Eingabekanäle und/oder mindestens zwei Ausgabekanäle, einen Taktgeber und einen Zähler umfasst, wobei der Zähler eingerichtet ist, um mit dem vollen Takt des Taktgebers beaufschlagt zu werden, wobei ein Kanal eingerichtet ist Signale mit einer durch eine Anzahl von Takten des Taktgebers bestimmten Abtastperiode zu verarbeiten, und
wobei die Verarbeitung von Signalen durch einen Kanal um einen durch eine Anzahl von Takten des Taktgebers bestimmten Versatz verzögert werden kann, das Echtzeitrechnersystem ferner umfassend einen Prozessor und einen programmierbaren Logikbaustein, wobei der Prozessor mit dem programmierbaren Logikbaustein verbunden ist, wobei der programmierbare Logikbaustein mit der Schnittstellenschaltung verbunden ist, **dadurch gekennzeichnet, dass** auf einem nichtflüchtigen Speicher des Echtzeitrechnersystems Instruktionen und/oder ein Bitstrom zur Durchführung eines Verfahrens nach einem der vorhergehenden Ansprüche hinterlegt sind.

12. Schnittstellenschaltung umfassend eine Gruppe von Ein- und/oder Ausgabekanälen aus mindestens zwei Eingabekanälen und/oder mindestens zwei Ausgabekanälen, wobei die Schnittstellenschaltung ferner einen Taktgeber, einen Zähler, einen programmierbaren Logikbaustein und einen mit diesem verbundenen nichtflüchtigen Speicher umfasst, wobei der Zähler eingerichtet ist, um mit dem vollen Takt des Taktgebers beaufschlagt zu werden, wobei ein Kanal eingerichtet ist Signale mit einer durch eine Anzahl von Takten des Taktgebers bestimmten Abtastperiode zu verarbeiten, und
wobei die Verarbeitung von Signalen durch einen Kanal um einen durch eine Anzahl von Takten des Taktgebers bestimmten Versatz verzögert werden kann, **dadurch gekennzeichnet, dass** auf dem nichtflüchtigen Speicher ein Bitstrom für den programmierbaren Logikbaustein hinterlegt ist, welcher den programmierbaren Logikbaustein zur Durchführung eines Verfahrens nach einem der Ansprüche 1 bis 10 einrichtet.

13. Schnittstellensystem nach Anspruch 12, **dadurch gekennzeichnet, dass** der Bitstrom des programmierbaren Logikbaustein eine Teilkonfiguration umfasst, welche eine Berechnung des Divisionsrest durchführt, und dass mindestens zwei Kanäle der mindestens zwei Eingabe- und/oder Ausgabekanäle eine gemeinsame Teilkonfiguration für die Berechnung des Divisionsrests verwenden.

14. Schnittstellensystem nach Anspruch 12, **dadurch gekennzeichnet, dass** der Bitstrom des programmierbaren Logikbaustein eine Teilkonfiguration umfasst, welche eine Berechnung des Divisionsrest durchführt, dass die verschiedenen möglichen Abtastperioden vordefiniert sind, und dass bei der Erstellung des Bitstroms die Breite des Zählers nach Maßgabe der möglichen Abtastperioden gewählt wird.

## Claims

1. Method for time-synchronized input and/or output of signals with a selectable sampling rate at a group of input and/or output channels of an electronic circuit, wherein the electronic circuit comprises at least two input channels and/or at least two output channels, a clock generator and a counter, wherein the counter is supplied with the full clock of the clock generator, wherein a channel processes signals with a predetermined sampling period determined by a number of clock pulses of the clock generator, the electronic circuit comprising at least two subcircuits each having at least one input channel and/or at least one output channel, a clock line to another subcircuit or a separate clock generator and a counter, the method comprising the successive steps of
a. configuring each channel of the group with a default sampling period,
b. synchronously starting all channels of the group with the default sampling period, wherein synchronously starting all channels of the group with the default sampling period comprises prior synchronization of the subcircuits' own clocks and counters so that all channels of the group are synchronous regardless of their location on a subcircuit, wherein the counter is also started,
c. detecting a preset for a changed sampling period T_{Periode} of a first channel of the group,
d. detecting a current counter value T_{Zähler},
e. configuring the first channel with the changed sampling period,
f. determining a waiting time of T_{Warte} clocks according to ${T}_{Warte} = {T}_{Periode} - mod \left({T}_{Zähler}, {T}_{Periode}\right) I$ where mod(T_{Zähler}, T_{Periode}) denotes the division remainder from the current counter value T_{Zähler} and the changed sampling period T_{Periode}, and
g. starting the first channel after the waiting time T_{Warte}.

2. Method according to claim 1, **characterized in that** the processing of signals by a channel is delayed by an offset determined by a number of clock pulses of the clock generator, **in that** the step of detecting a preset for a changed sampling period additionally comprises detecting a preset for a changed offset T_{Versatz}, and **in that** the changed offset is used in the determination of the waiting time according to ${T}_{Warte} = {T}_{Period} - mod \left({T}_{Zähler}, {T}_{Periode}\right) + {T}_{Versatz} ,$ whereby T_{Versatz}=0 is set if no changed offset was detected.

3. Method according to claim 1 or 2, **characterized in that** the at least two input channels and/or at least two output channels require a conversion time T_{Min} of more than one clock for processing a signal, the waiting time according to T_{Warte} = T_{Warte} + T_{Periode} being extended by a modified sampling period if the time difference between the start time T_{Zähler} + T_{Warte} with modified sampling period and the time t_{Sample} of the start of the last processing of a signal according to T_{Zähler} + T_{Warte} - t_{Sample} < T_{Min} would fall below the conversion time T_{Min}.

4. Method according to claim 3, **characterized in that** the required conversion period T_{Min} of a channel is stored in a memory which is read out when the sampling period for the channel is changed, and the waiting time is extended on the basis of the read-out conversion period, in particular the waiting time is extended by a plurality n > 1 of periods according to ${T}_{Warte} = {T}_{Warte} + n * {T}_{Periode} .$

5. Method according to one of the preceding claims, **characterized in that** at least two input channels receive the same signal, the at least two input channels being operated with the same sampling period, in particular the shortest possible sampling period, and a first constant offset between adjacent channels, and **in that** a new constant offset is set when a triggering condition is fulfilled, in particular half of the first constant offset.

6. Method according to one of the preceding claims, **characterized in that** an input channel is operated with a first sampling period and is configured to a second sampling period, in particular a shorter sampling period, when a trigger condition is fulfilled.

7. Method according to one of the preceding claims, **characterized in that** each subcircuit is arranged on a separate FPGA module, preferably a central circuit being connected to two or more subcircuits, in particular the clock for the subcircuits being distributed to the subcircuits by the clock generator of the central circuit.

8. Method according to one of the preceding claims, **characterized in that** the electronic circuit has a freely programmable FPGA module whose configuration is rewritten when a simulation is initialized, the configuration of the freely programmable FPGA module being set up to execute at least one step of the method according to the invention for at least one channel, preferably for all the channels used.

9. Method according to claim 8, **characterized in that** the electronic circuit is connected to an operating computer on which a graphical user interface with a graphical representation of the model to be simulated is executed, and **in that** a channel object, in particular a block, is represented in the graphical user interface for at least one channel, preferably the configuration of the freely programmable FPGA module is generated on the basis of the graphical representation of the model to be simulated.

10. Method according to claim 9, **characterized in that** the channel object is set up to receive signals from the simulated model via ports and/or to output signals to the simulated model, in particular a port which indicates with clock accuracy when the assigned channel has been started with a new sampling period, and/or a port which indicates in how many clocks a newly set sampling rate becomes effective, and/or a port via which a specification for the offset of the channel by a number of clocks is received.

11. A real-time computer system comprising an interface circuit having a group of input and/or output channels, wherein the interface circuit comprises at least two input channels and/or at least two output channels, a clock and a counter, wherein the counter is arranged to be supplied with the full clock of the clock generator, wherein a channel is arranged to process signals with a sampling period determined by a number of clocks of the clock generator, and wherein the processing of signals by a channel can be delayed by an offset determined by a number of clock pulses of the clock generator, the real-time computer system further comprising a processor and a programmable logic device, wherein the processor is connected to the programmable logic device, wherein the programmable logic device is connected to the interface circuit, **characterized in that** instructions and/or a bit stream for performing a method according to one of the preceding claims are stored on a non-volatile memory of the real-time computer system.

12. An interface circuit comprising a group of input and/or output channels of at least two input channels and/or at least two output channels, the interface circuit further comprising a clock generator, a counter, a programmable logic device and a non-volatile memory connected thereto, wherein the counter is arranged to be supplied with the full clock of the clock generator, wherein a channel is arranged to process signals with a sampling period determined by a number of clock pulses of the clock generator, and wherein the processing of signals by a channel can be delayed by an offset determined by a number of clock pulses of the clock generator, **characterized in that** a bit stream for the programmable logic device is stored on the non-volatile memory, which sets up the programmable logic device for carrying out a method according to one of claims 1 to 10.

13. interface system according to claim 12, **characterized in that** the bit stream of the programmable logic device comprises a partial configuration which performs a calculation of the division remainder, and **in that** at least two channels of the at least two input and/or output channels use a common partial configuration for the calculation of the division remainder.

14. interface system according to claim 12, **characterized in that** the bit stream of the programmable logic device comprises a partial configuration which performs a calculation of the division remainder, **in that** the various possible sampling periods are predefined, and **in that**, when the bit stream is created, the width of the counter is selected in accordance with the possible sampling periods.

## Revendications

1. Procédé pour l'entrée et/ou la sortie synchronisée dans le temps de signaux avec une fréquence d'échantillonnage sélectionnable sur un groupe de canaux d'entrée et/ou de sortie d'un circuit électronique, le circuit électronique comprenant au moins deux canaux d'entrée et/ou au moins deux canaux de sortie, un générateur d'horloge et un compteur, le compteur étant alimenté par l'horloge complète du générateur d'horloge, un canal traitant des signaux avec une période d'échantillonnage prédéterminée déterminée par un nombre d'horloges de l'horloge, le circuit électronique comprenant au moins deux sous-circuits, chacun ayant au moins un canal d'entrée et/ou au moins un canal de sortie, une ligne d'horloge vers un autre sous-circuit ou un générateur d'horloge propre et un compteur, le procédé comprenant les étapes successives :
a. configurer chaque canal du groupe avec une période d'échantillonnage standard,
b. démarrer de manière synchrone tous les canaux du groupe avec la période d'échantillonnage standard, le démarrage synchrone de tous les canaux du groupe avec la période d'échantillonnage standard comprenant une synchronisation préalable des générateurs d'horloges et compteurs propres des sous-circuits, de sorte que tous les canaux du groupe soient synchronisés indépendamment de leur disposition sur un sous-circuit, le compteur étant également démarré,
c. détecter une consigne pour une période d'échantillonnage modifiée T_{Periode} d'un premier canal du groupe,
d. détection d'une valeur de compteur actuelle T_{Zähler},
e. configurer le premier canal avec la période d'échantillonnage modifiée,
f. détermination d'un temps d'attente de T_{Warte} horloges selon ${T}_{Warte} = {T}_{Periode} - mod \left({T}_{Zähler}, {T}_{Periode}\right) I$ où mod(T_{Zähler}, T_{Periode}) désigne le reste de la division entre la valeur de compteur actuelle T_{Zähler} et la période d'échantillonnage modifiée T_{Periode}, et
g. démarrage du premier canal après le temps d'attente T_{Warte}.

2. Procédé selon la revendication 1, **caractérisé en ce que** le traitement de signaux par un canal est retardé d'un décalage déterminé par un nombre d'horloge du générateur d'horloge, **en ce que** l'étape de détection d'une consigne pour une période d'échantillonnage modifiée comprend en outre la détection d'une consigne pour un décalage modifié T_{Versatz}, et **en ce que** le décalage modifié est pris en compte dans la détermination du temps d'attente selon la formule ${T}_{Warte} = {T}_{Periode} - mod \left({T}_{Zähler}, {T}_{Periode}\right) + {T}_{Versatz} , où {T}_{Versatz} = 0$ est fixé si aucun décalage modifié n'a été détecté.

3. Procédé selon la revendication 1 ou 2, **caractérisé en ce que** les au moins deux canaux d'entrée et/ou les au moins deux canaux de sortie nécessitent une durée de conversion T_{Min} de plus d'une horloge pour le traitement d'un signal, le temps d'attente selon T _{Warte} = T _{Warte} + T _{Periode} étant prolongé d'une période d'échantillonnage modifiée au cas où la différence de temps entre l'instant de départ T_{Zähler} + T_{Warte} avec période d'échantillonnage modifiée et l'instant t_{Sample} du début du dernier traitement d'un signal selon T_{Zähler} + T_{Warte} - t_{Sample} < T_{Min} serait inférieure à la durée de conversion T_{Min}.

4. Procédé selon la revendication 3, **caractérisé en ce que** la durée de conversion nécessaire T _{Min} d'un canal est enregistrée dans une mémoire qui est lue lors d'une modification de la période d'échantillonnage pour le canal, et le temps d'attente est prolongé à l'aide de la durée de conversion lue, en particulier le temps d'attente selon T _{Warte} = T_{Warte} + n * T_{Periode} est prolongé d'une pluralité n > 1 de périodes.

5. Procédé selon l'une des revendications précédentes, **caractérisé en ce qu'**au moins deux canaux d'entrée reçoivent le même signal, les au moins deux canaux d'entrée fonctionnant avec la même période d'échantillonnage, notamment la période d'échantillonnage la plus courte possible, et un premier décalage constant entre des canaux voisins, et **en ce que**, lorsqu'une condition de déclenchement est remplie, un nouveau décalage constant est réglé, notamment la moitié du premier décalage constant.

6. Procédé selon l'une quelconque des revendications précédentes, **caractérisé en ce qu'**un canal d'entrée est exploité avec une première période d'échantillonnage et est configuré pour une deuxième période d'échantillonnage, en particulier une période d'échantillonnage plus courte, lorsqu'une condition de déclenchement est remplie.

7. Procédé selon l'une des revendications précédentes, **caractérisé en ce que** chaque sous-circuit est disposé sur un composant FPGA séparé, de préférence un circuit central étant relié à deux ou plusieurs sous-circuits, en particulier l'horloge pour les sous-circuits étant distribuée aux sous-circuits par générateur d'horloge du circuit central.

8. Procédé selon l'une des revendications précédentes, **caractérisé en ce que** le circuit électronique comporte un composant FPGA librement programmable dont la configuration est réécrite lors de l'initialisation d'une simulation, la configuration du composant FPGA librement programmable étant agencée pour exécuter au moins une étape du procédé selon l'invention pour au moins un canal, de préférence pour tous les canaux utilisés.

9. Procédé selon la revendication 8, **caractérisé en ce que** le circuit électronique est relié à un ordinateur de commande sur lequel est exécutée une interface utilisateur graphique avec une représentation graphique du modèle à simuler, et **en ce que**, pour au moins un canal, un objet canal, en particulier un bloc, est représenté dans l'interface utilisateur graphique, de préférence la configuration du bloc FPGA librement programmable est générée à l'aide de la représentation graphique du modèle à simuler.

10. Procédé selon la revendication 9, **caractérisé en ce que** l'objet de canal est conçu pour recevoir des signaux du modèle simulé et/ou émettre des signaux vers le modèle simulé par l'intermédiaire de ports, en particulier un port qui indique avec une précision d'horloge lorsque le canal associé a été démarré avec une nouvelle période d'échantillonnage, et/ou un port qui indique dans combien d'horloges une fréquence d'échantillonnage nouvellement réglée devient effective, et/ou un port par l'intermédiaire duquel une consigne pour le décalage du canal d'un nombre d'horloges est reçue.

11. Système informatique en temps réel comprenant un circuit d'interface avec un groupe de canaux d'entrée et/ou de sortie, le circuit d'interface comprenant au moins deux canaux d'entrée et/ou au moins deux canaux de sortie, un générateur d' horloge et un compteur, le compteur étant agencé pour être alimenté par la pleine horloge du générateur d' 'horloge, un canal étant agencé pour traiter des signaux avec une période d'échantillonnage déterminée par un nombre d'horloges du générateur d' horloge, et dans lequel le traitement de signaux par un canal peut être retardé d'un décalage déterminé par un nombre d'horloges du générateur d' 'horloge, le système informatique en temps réel comprenant en outre un processeur et un module logique programmable, le processeur étant connecté au module logique programmable, le module logique programmable étant connecté au circuit d'interface, **caractérisé en ce que** des instructions et/ou un flux binaire pour l'exécution d'un procédé selon l'une des revendications précédentes sont déposés sur une mémoire non volatile du système informatique en temps réel.

12. Circuit d'interface comprenant un groupe de canaux d'entrée et/ou de sortie composé d'au moins deux canaux d'entrée et/ou d'au moins deux canaux de sortie, le circuit d'interface comprenant en outre un générateur d' horloge, un compteur, un composant logique programmable et une mémoire non volatile connectée à celui-ci, le compteur étant agencé pour être alimenté par la pleine horloge du générateur d' horloge, un canal étant agencé, pour traiter des signaux avec une période d'échantillonnage déterminée par un nombre d'horloges du générateur d' horloge, et dans lequel le traitement de signaux par un canal peut être retardé d'un décalage déterminé par un nombre d'horloges du générateur d'horloge, **caractérisé en ce qu'**un flux binaire pour le module logique programmable est enregistré dans la mémoire non volatile, lequel module logique programmable est configuré pour exécuter un procédé selon l'une des revendications 1 à 10.

13. Système d'interface selon la revendication 12, **caractérisé en ce que** le flux binaire du module logique programmable comprend une configuration partielle qui effectue un calcul du reste de division, et **en ce qu'**au moins deux canaux des au moins deux canaux d'entrée et/ou de sortie utilisent une configuration partielle commune pour le calcul du reste de division.

14. Système d'interface selon la revendication 12, **caractérisé en ce que** le flux binaire du module logique programmable comprend une configuration partielle qui effectue un calcul du reste de division, **en ce que** les différentes périodes d'échantillonnage possibles sont prédéfinies, et **en ce que**, lors de la création du flux binaire , la largeur du compteur est choisie en fonction des périodes d'échantillonnage possibles.
